# EUROPÄISCHE PATENTSCHRIFT

(11) **EP 0 432 639 B1**
(45) Veröffentlichungstag und Bekanntmachung des Hinweises auf die Patenterteilung: **24.05.1995**
(21) Anmeldenummer: 90123409.6
(22) Anmeldetag: 06.12.1990
(51) Int. Cl.: G01R 31/36

(54) **Überwachungseinrichtung für Akkumulatoren**
Monitoring device for accumulators
Dispositif de surveillance pour accumulateurs

(30) Priorität: 12.12.1989 DE 3940928
(43) Veröffentlichungstag der Anmeldung: 19.06.1991
(73) Patentinhaber: FRAUNHOFER-GESELLSCHAFT ZUR FÖRDERUNG DER ANGEWANDTEN FORSCHUNG E.V., 80636 München (DE)
(72) Erfinder: Schmidt, Heribert, Dr., W-7830 Emmendingen 13 (DE)
(74) Vertreter: Rackette, Karl, Dipl.-Phys. Dr.-Ing

(56) Entgegenhaltungen:
- DE-A- 3 141 622
- FR-A- 2 360 203
- US-A- 3 872 457
- US-A- 4 331 911
- Prospektblatt ZAT 100 der Helmut Händel + Partner Me$datentechnik KG, 8031 Eichenau

## Beschreibung

Die Erfindung betrifft eine Überwachungseinrichtung für eine Vielzahl von in Reihe geschalteten, gleichartigen Akkumulatoren, mit einer Steuerschaltung zum Zuschalten eines elektrischen Speichers parallel zu einem der Akkumulatoren, wobei die Primärwicklung eines Transformators in Reihe mit einem an die Steuerschaltung angeschlossenen Unterbrecher parallel zu den Polen der Gruppe von Akkumulatoren verbunden ist.

Eine solche Überwachungseinrichtung ist aus der US-A-4 331 911 bekannt und dient zum Angleichen von Spannungen einzelner, in Reihe geschalteter Akkumulatoren mit einem DC-DC-Wandler. Der einzige zentrale Wandler für alle Akkumulatoren wird aus der Gesamtbatterie gespeist und er ist nicht fähig, durch Alterung auftretende Besonderheiten einzelner Akkumulatoren zu detektieren.

Aus dem Prospektblatt ZAT 100 der Helmut Händel + Partner, Meßdatentechnik KG, 8031 Eichenau, ist eine zyklische Überwachungseinrichtung für Akkumulatoren bekannt, bei der jeweils ein Akkumulator unterbrechungsfrei aus dem Akkumulatorsystem getrennt und geprüft wird. Wird ein Akkumulator von der Überwachungseinrichtung als schlecht bewertet, so wird der entsprechende Akkumulator markiert, damit er ausgewechselt werden kann.

Bis ein solcher, in seiner Speicherungs- und Ladungsqualität absinkender Akkumulator von der Überwachungseinrichtung für Akkumulatoren erkannt wird, führt sein Fehlverhalten zu einer Kette von Reaktionen in der Gruppe der Akkumulatoren, was zu einer Degradation auch der anderen Akkumulatoren führt.

In der DE-PS 30 31 931 ist eine Vorrichtung zur Verlängerung der Entladungsdauer von wiederaufladbaren Akkumulatoren beschrieben, bei der mit einer Überwachungseinrichtung die Spannungszustände der Akkumulatoren erfaßt werden. Es wird eine längere betriebssichere Entladung der Akkumulatoren dadurch bewirkt, daß der Akkumulatorbetrieb nicht bei Entladung und damit bei Erreichen einer Grenzspannung der schwächsten Zelle beendet wird, sondern erst, wenn diese Grenzspannung im Mittel aller zusammengeschalteten Akkumulatoren erreicht wird. Eine Verlängerung der Standzeit von Akkumulatoren im Hinblick auf ihre Auswechslung läßt sich damit nicht erreichen.

Aus der SU 1 065 959 ist eine Vorrichtung für ein Akkumulatorladegerät bekannt, mit der das Überladen und das Laden mit Falschpolung von Akkumulatoren verhindert wird. Dabei wird der Ladestrom über eine Transistorschaltung überwacht, die weiterhin Zenerdioden umfaßt. Diese Schutzschaltung kann jedoch weder die Überwachung der Qualität der Akkumulatoren gewährleisten, noch eine längere Standzeit von in ihrer Qualität schlechter werdenden Akkumulatoren bewirken.

Ausgehend von diesem Stand der Technik liegt der Erfindung die Aufgabe zugrunde, eine Überwachungseinrichtung für Akkumulatoren zu schaffen, bei dem der Austausch eines in seiner Qualität schlechteren Akkumulators hinausgezögert werden kann.

Diese Aufgabe wird für eine Überwachungseinrichtung gemäß dem Oberbegriff des Anspruchs 1 erfindungsgemäß zum einen dadurch gelöst, daß die Polanschlüsse jeden Akkumulators über jeweils eine einen Rückstrom aus dem Akkumulator unterbindende Diode mit einer zugeordneten und den elektrischen Speicher bildenden Sekundärwicklung des Transformators verbunden sind, wobei ein einziger Transformator vorgesehen ist, der eine Anzahl von Sekundärwicklungen umfaßt, die der Anzahl der Akkumulatoren entspricht, und daß jeder Akkumulator mit einer Vergleichsschaltung verbunden ist, deren jeweilige Ausgangssignale in einer ODER-Verknüpfungsschaltung einen Eingang der Steuerschaltung beaufschlagen, die bei einem Istspannungs-Differenzsignal einen in der Steuerschaltung vorgesehenen Funktionsgenerator anschaltet, dessen Ausgang mit dem Unterbrecher verbunden ist.

Der sich mit einer Umschaltfrequenz im Kilohertzbereich öffnende und schließende Unterbrecher bildet zusammen mit dem Transformator einen Sperrwandler für die angeschalteten Akkumulatoren, wobei der spannungsschwächste der Akkumulatoren von den Sperrdioden ausgewählt wird und die anderen Akkumulatoren von dem Transformator abgekoppelt sind, so daß ein Stromfluß aus der Gesamtheit der Akkumulatorengruppe in den schwachen Akkumulator fließt und dessen Ladungszustand stützt.

Wenn der einzige Transformator eine Anzahl von Sekundärwicklungen umfaßt, die der Anzahl der Akkumulatoren entspricht, ist die genannte Vergleichsschaltung je Akkumulator vorgesehen, wobei der den Unterbrecher antreibende Funktionsgenerator nur dann betrieben wird, wenn der Ladungszustand einer der Akkumulatoren es erfordert, so daß die Verlustleistung der Überwachungseinrichtung klein bleibt.

Die Aufgabe wird weiterhin für eine Überwachungseinrichtung gemäß dem Oberbegriff des Anspruchs 2 erfindungsgemäß dadurch gelöst, daß die Polanschlüsse jeden Akkumulators über jeweils eine einen Rückstrom aus dem Akkumulator unterbindende Diode mit einer zugeordneten und den elektrischen Speicher bildenden Sekundärwicklung des Transformators verbunden sind, wobei ein einziger Transformator vorgesehen ist, der eine Anzahl von Sekundärwicklungen umfaßt, deren Anzahl um eins erhöht ist gegenüber der Zahl der Akkumulatoren vorbestimmt ist, und daß die über die Anzahl der Akkumulatoren hinaus vorgesehene Hilfssekundärwicklung mit einem Spannungsmesser verbunden ist, dessen Ausgang mit einer Vergleichsschaltung verbunden ist, deren Ausgangssignal einen Eingang der Steuerschaltung beaufschlagt, die bei einem Istspannungs-Differenzsignal einen in der Steuerschaltung vorgesehenen Funktionsgenerator anschaltet, dessen Ausgang mit dem Unterbrecher verbunden ist, und daß eine Zeitschaltung in der Steuerschaltung vorgesehen ist, die den Funktionsgenerator periodisch zeitweilig und unabhängig von einem Istspannungs-Differenzsignal anschaltet.

Wenn die Zahl der Sekundärwicklungen des einzigen Transformators der um eins erhöhten Zahl der Akkumulatoren entspricht, ist eine Vergleichsschaltung und eine Zeitschaltung vorgesehen, wobei die Zeitschaltung in der Steuerschaltung bewirkt, daß der Funktionsgenerator periodisch zeitweilig und unabhängig von einem Istspannungs-Differenzsignal angeschaltet wird, um die Akkumulatorspannungen mit Hilfe des Spannungsmessers zu überwachen.

Schließlich wird die Aufgabe für eine Überwachungseinrichtung gemäß dem Oberbegriff des Anspruchs 3 erfindungsgemäß dadurch gelöst, daß die Polanschlüsse jeden Akkumulators über jeweils eine einen Rückstrom aus dem Akkumulator unterbindende Diode mit einer zugeordneten und den elektrischen Speicher bildenden Sekundärwicklung des Transformators verbunden sind, wobei eine Anzahl von Überwachungsmodulen vorgesehen ist, die jeweils einen Transformator und einen mit dessen Primärwicklung in Reihe geschalteten Unterbrecher je zu überwachenden Akkumulator umfassen, wobei jeder Akkumulator mit einer Vergleichsschaltung verbunden ist, deren Ausgang mit dem Eingang der dem jeweiligen Akkumulator zugeordneten Steuerschaltung verbunden ist, die einen den Unterbrecher ansteuernden Funktionsgenerator umfaßt.

Ein modularer Aufbau der Überwachungseinrichtung umfaßt eine Anzahl von Überwachungsmodulen, wobei für jeden Akkumulator eine Vergleichsschaltung vorgesehen ist. Dadurch kann die Überwachungseinrichtung leicht an eine Vielzahl von Stromversorgungen angepaßt werden und ist jeweils in ein Akkumulatorpaket integrierbar. Der erhebliche Verkabelungsaufwand zu einer Schaltzentrale von 40 oder mehr Akkumulatoren entfällt zugunsten einer kurzen Verdrahtung zwischen jeweils benachbarten Überwachungsmodulen.

Ein erweiterter modularer Aufbau der Überwachungseinrichtung umfaßt eine Anzahl von Überwachungsmodulen, die jeweils einen bidirektional wirkenden Sperrwandler umfassen, so daß je nach relativem Ladezustand des zugeordneten Akkumulators sowohl dessen gezielte Ladung als auch Entladung möglich ist. Für jeden Akkumulator ist eine Vergleichsschaltung vorgesehen, deren Ausgänge mit dem jeweiligen Akkumulator zugeordneten Steuerschaltungen verbunden ist

Weitere Ausgestaltungen der Erfindung sind in den Unteransprüchen gekennzeichnet.

Nachfolgend werden vier Ausführungsbeispiele der Erfindung anhand der Zeichnung näher erläutert. Es zeigen:
- Fig. 1: ein Blockschaltbild einer Überwachungseinrichtung für drei Akkumulatoren gemäß einem ersten Ausführungsbeispiel,
- Fig. 2: ein Blockschaltbild einer modularen Überwachungseinrichtung für drei Akkumulatoren gemäß einem zweiten Ausführungsbeispiel,
- Fig. 3: ein Beispiel für eine Realisierungsmöglichkeit einer Vergleichsschaltung einer Überwachungseinrichtung,
- Fig. 4: ein Blockschaltbild einer modularen Überwachungseinrichtung für drei Akkumulatoren gemäß einem dritten Ausführungsbeispiel,
- Fig. 5: eine zweite Realisierungsmöglichkeit für eine Vergleichsschaltung einer Überwachungseinrichtung für Akkumulatoren, und
- Fig. 6: ein Blockschaltbild einer modularen Überwachungseinrichtung für drei Akkumulatoren gemäß einem vierten Ausführungsbeispiel.

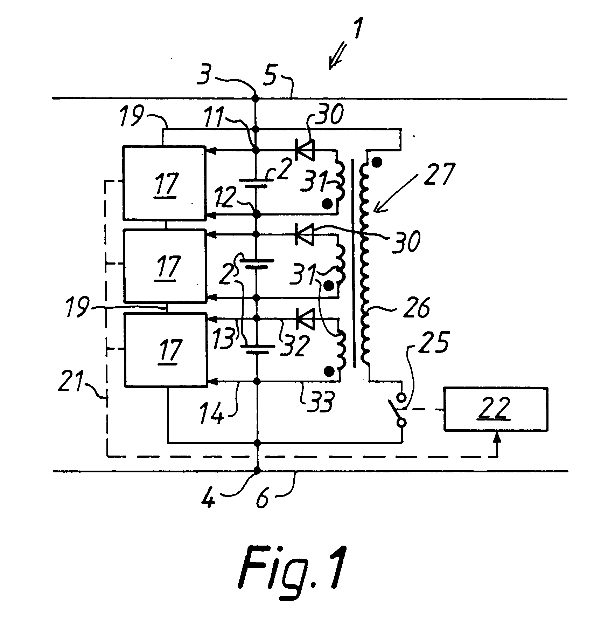

Die Fig. 1 zeigt ein Blockschaltbild einer Überwachungseinrichtung 1 für Akkumulatoren zur Überwachung von z.B. drei Akkumulatoren 2. In üblichen Spannungsversorgungen mit Akkumulatoren 2 sind z.B. 35 6-Volt-Akkumulatoren zusammengeschaltet um eine Spannung von ungefähr 200 Volt zu erzeugen. Die in der Fig. 1 dargestellten drei Akkumulatoren 2 sind in Reihe geschaltet und werden an den Hauptanschlußpunkten 3 und 4 an zwei Hauptleitungen 5 und 6 angeschlossen, von denen üblicherweise die Hauptleitung 6 die Masseleitung ist und sich die Hauptleitung 5 auf einem positiven Potential befindet.

Die Hauptleitungen 5 und 6 sind zum Laden der Akkumulatoren 2 an einem in der Fig. 1 nicht dargestellten Ladegerät oder Solargenerator mit konventionellem Laderegler angeschlossen. Desweiteren ist üblicherweise eine in der Fig. 1 ebenfalls nicht dargestellte Last an die Akkumulatoren 2 angeschlossen. Diese bewirkt eine Entladung der Akkumulatoren 2. Je nach Sonneneinstrahlung auf die Solargeneratoren bzw. die Ladungsentnahme durch die angeschlossene Last schwankt der Ladungszustand der Akkumulatoren 2 beträchtlich. Die Überwachungseinrichtung 1 regelt die Ladung und die Entladung der Akkumulatoren 2 bei Ladungszuständen von diesen zwischen vollgeladen und ganz entladen.

Jeder Akkumulator 2 verfügt über zwei externe Anschlußpunkte 11 und 12, an denen die Gesamtspannung des Akkumulators 2 anliegt. Über die Anschlußpunkte 11 und 12 ist jeder Akkumulator 2 mit dem jeweils benachbarten Akkumulator 2 bzw. mit den Hauptleitungen 5 oder 6 verbunden.

Im Idealfall von Akkumulatoren 2 gleicher Güte liegt jeweils zwischen den Anschlußpunkten 11 und 12 die gleiche Spannung an, nämlich ein Drittel der Gesamtspannung des Akkumulatorsystems bei drei Akkumulatoren 2. Die zwischen den Anschlußpunkten 11 und 12 abgegriffene Spannung beaufschlagt über Istwertleitungen 13 und 14 eine Vergleichsschaltung 17.

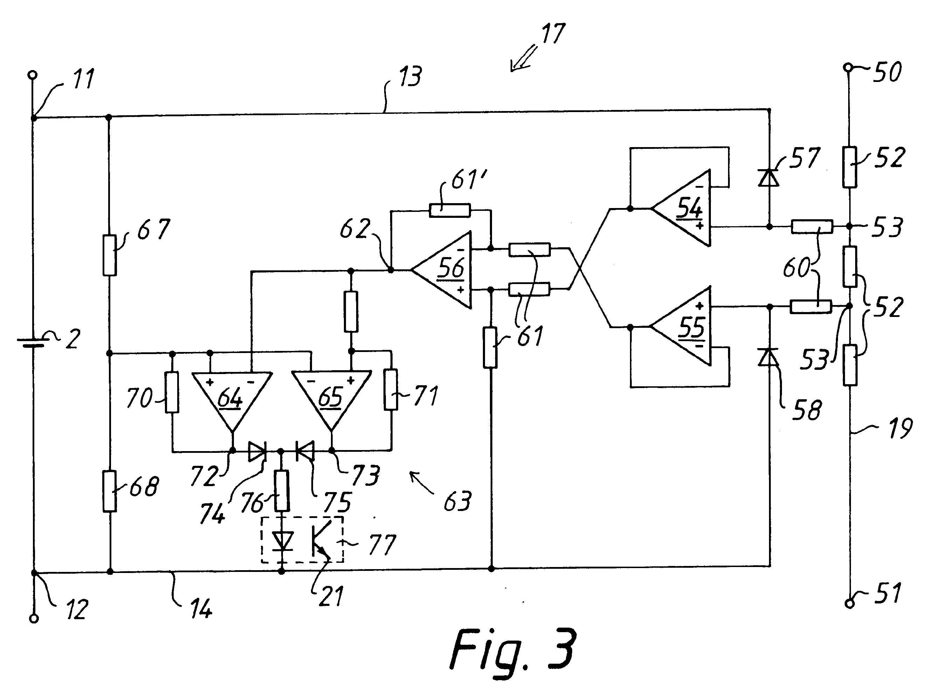

Vorteilhafterweise verfügt die Vergleichsschaltung 17 über eine über schematisch dargestellte Außenleitungen 19 anliegende Referenzspannung. Diese kann, wie in Fig. 3 dargestellt, durch einen Spannungsteiler erzeugt werden. Die Vergleichsschaltung 17 bildet aus der durch die Außenleitung 19 vorgegebenen, augenblicklichen Sollspannung des Akkumulators 2 und der augenblicklichen Istspannung des Akkumulators 2 eine Differenzspannung, die über eine schematisch dargestellte Steuerleitung 21 eine Ansteuerschaltung 22 beaufschlagt. Der von der Vergleichsschaltung 17 in die Ansteuerschaltung 22 führende strich-linierte Pfeil beschreibt schematisch einen Datenbus mit einer Vielzahl von Leitungen. Es kann auch eine einzige Leitung vorgesehen sein, wobei die Ausgänge der Vergleichsschaltungen 17 in einer verdrahteten ODER-Verknüpfung verbunden sind.

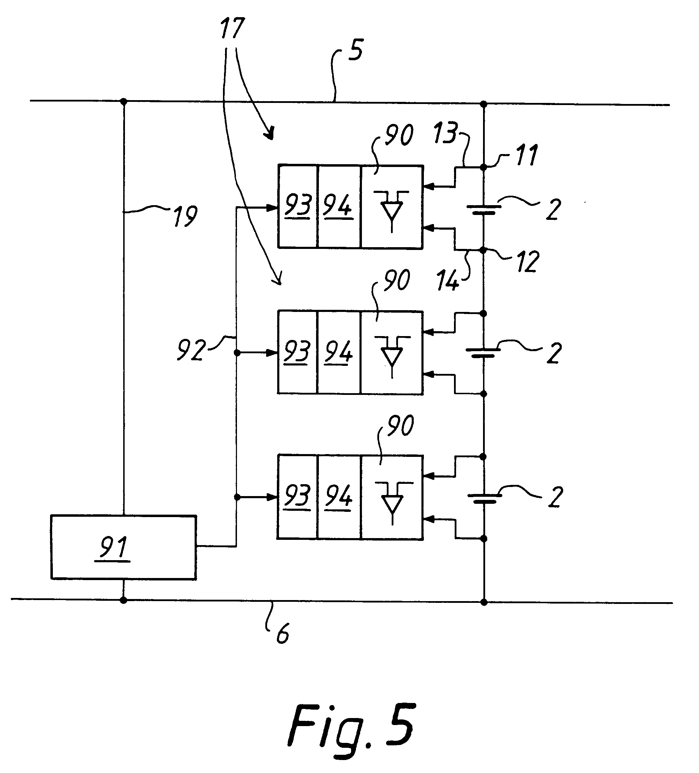

Zwei Ausführungsformen der Vergleichsschaltung 17 sind in den Fig. 3 und 5 dargestellt. Die auf den Steuerleitungen 21 transportierten Steuersignale bestehen z.B. aus einem zwei oder drei Werte umfassenden Ausgangssignal eines Komparators.

Die Ansteuerschaltung 22 umfaßt einen Rechteck-Funktionsgenerator, der vorzugsweise mit einem Tastverhältnis von kleiner als 50 Prozent betrieben wird. Beim Einschalten des Rechteckgenerators durch ein entsprechendes Signal auf der Steuerleitung 21 ist vorteilhafterweise ein Anlaufschutz für die Überwachungseinrichtung 1 mit einem von null Prozent bis auf den voreingestellten Wert ansteigendem Tastverhältnis vorgesehen. Desweiteren ist eine elektronische Überstrombegrenzung vorgesehen.

Das Ausgangssignal des Rechteckgenerators, das beispielsweise eine Frequenz zwischen 10 und 100 Kilohertz aufweist, beaufschlagt einen Unterbrecher 25. Der Unterbrecher 25 ist vorzugsweise mit einem MOS-Feldeffekttransistor oder bipolaren Transistoren realisiert. Der Unterbrecher 25 ist zwischen den Hauptleitungen 5 und 6 in Reihe mit einer Primärwicklung 26 eines Transformators 27 angeordnet. Der Unterbrecher 25 und die Primärwicklung 26 sind zusammen parallel zu der Akkumulatorgruppe geschaltet und bilden einen Sperrwandler.

Die Sekundärseite des Transformators 27 beinhaltet eine Anzahl von Sekundärwicklungen 31, die der Anzahl der zu überwachenden Akkumulatoren 2 entspricht. Die in der Fig. 1 dargestellten drei Sekundärwicklungen 31 verfügen alle über die gleiche Anzahl von Windungen, wobei die Summe aller Windungen der Sekundärwicklungen 31 vorteilhafterweise der Anzahl der Windungen der Primärwicklung 26 entspricht. Gegenüber jeder Sekundärwicklung 31 ergibt sich also ein Windungsverhältnis von 3:1.

Jede Sekundärwicklung 31 ist parallel zu dem ihr zugeordneten Akkumulator 2 geschaltet. In der ein höheres Potential aufweisenden Sekundärseitenleitung 32 oder in der ein niedrigeres Potential aufweisenden Sekundärseitenleitung 33 ist eine Sperrdiode 30 angeordnet, die bezüglich dem Akkumulator 2 in Sperrichtung angeordnet ist, so daß sie einen Rückstrom aus dem Akkumulator 2 unterbindet. Vorteilhafterweise ist diese, eine niedrige Durchlaßspannung aufweisende Diode 30 mit ihrer Kathode mit dem das höhere Potential aufweisenden Anschlußpunkt 11 verbunden.

Beim Laden der Akkumulatoren 2 wird den Akkumulatoren 2 durch die Solarzellen oder z.B. von einem Dieselmotor-Stromgenerator Ladung zugeführt. Die jeweilige Spannung jedes Akkumulators 2 wird mit seiner Sollspannung in der Vergleichsschaltung 17 verglichen und das Ergebnis direkt in Gestalt einer analogen Spannung oder als Ausgangssignal eines Komparators an die Ansteuerschaltung 22 weitergeleitet. Nun gibt es bei der Hintereinanderschaltung von üblicherweise 30 und mehr Akkumulatoren 2 einige Akkumulatoren 2, die schlechter aufladen als der Durchschnitt der verwendeten Akkumulatoren 2.

Dies äußert sich in einer jeweils geringeren Istspannung des betreffenden Akkumulators 2, die von einer der Vergleichsschaltungen 17 detektiert wird. Zur Unterstützung des Ladungsvorgangs dieses schwachen Akkumulators 2 löst das auf der Steuerleitung 21 die Ansteuerschaltung 22 beaufschlagende Differenzsignal das Einschalten des Rechteckgenerators aus, der den Unterbrecher 25 in schnellem Wechsel öffnet und schließt. Die an der Primärwicklung 26 anliegende Spannung induziert eine gemäß dem Windungsverhältnis schwächere Spannung an den Sekundärwicklungen 31, die der Sollspannung der Akkumulatoren entspricht. Übertrifft nun diese Sollspannung, vermindert um die Durchlaßspannung der Diode 30, die Spannung eines schwachen Akkumulators, so wird diese Diode 30 leitend und ein Ausgleichsstrom aus der Gesamtheit der Akkumulatoren 2 fließt in den schwachen Akkumulator 2. Dessen schwächere Aufladung wird so durch einen etwas erhöhten Energiezufluß ausgeglichen.

Die oben beschriebenen Ausgleichsvorgänge beim Laden von unterschiedlich gut aufladenden Akkumulatoren 2 gelten analog für die Ausgleichsvorgänge, die beim Entladen derselben Akkumulatoren 2 auftreten. Immer wird die Ausgangsspannung der Sekundärseite durch die niedrigste Akkumulatorspannung bestimmt. Die übrigen Akkumulatoren 2 sind aufgrund der Ventilwirkung der jeweiligen Dioden 30 abgekoppelt.

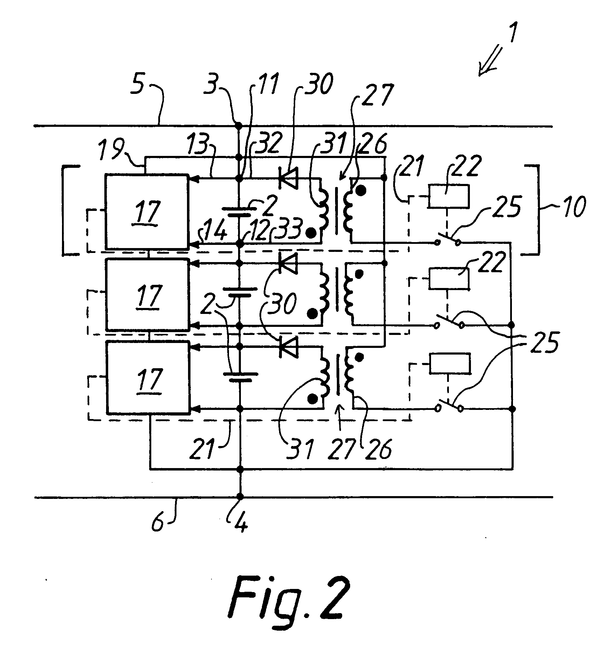

Das in der Fig. 2 dargestellte zweite Ausführungsbeispiel weist einen vorteilhaften modularen Aufbau auf, der Überwachungsmodule 10 vorsieht, die jeweils aus einer Diode 30, einem Transformator 27, einem Unterbrecher 25, einer Ansteuerschaltung 22 und einer Vergleichsschaltung 17 aufgebaut sind. Gleiche Merkmale tragen die gleichen Bezugszeichen wie in Fig. 1 beim ersten Ausführungsbeispiel.

Die zwischen den Anschlußpunkten 11 und 12 abgegriffene Spannung jeden Akkumulators 2 beaufschlagt über die Istwertleitungen 13 und 14 jeweils eine Vergleichsschaltung 17. Die Vergleichsschaltung 17 bildet aus der durch die Außenleitung 19 vorgegebenen, augenblicklichen Sollspannung des Akkumulators 2 und der augenblicklichen Istspannung des Akkumulators 2 eine Differenzspannung, die über eine schematisch dargestellte Steuerleitung 21 die dem jeweiligen Akkumulator 2 zugeordnete Ansteuerschaltung 22 beaufschlagt.

Jede Ansteuerschaltung 22 umfaßt einen Rechteck-Funktionsgenerator. Entsprechend dem ersten Ausführungsbeispiel ist vorteilhafterweise ein Anlaufschutz für jedes Überwachungsmodul 10 vorgesehen. Das Ausgangssignal des Rechteckgenerators beaufschlagt einen dem Überwachungsmodul 10 zugeordneten Unterbrecher 25. Der Unterbrecher 25 ist zwischen den Hauptleitungen 5 und 6 in Reihe mit einer Primärwicklung 26 eines dem besagten Akkumulator 2 zugeordneten Transformators 27 angeordnet. Die in Reihe mit den Primärwicklungen 26 angeordneten Unterbrecher 25 sind alle jeweils parallel zu der Akkumulatorengruppe geschaltet und bilden einzelne Sperrwandler.

Jede der Primärwicklungen 26 weist eine Wicklungszahl auf, die vorzugsweise der Wicklungszahl der einzigen Primärwicklung 26 aus dem ersten Ausführungsbeispiel entspricht. Die Sekundärseite jedes Transformators 27 beinhaltet eine Sekundärwicklung 31 mit der gleichen Anzahl von Windungen wie jede der Sekundärwicklungen 31 im ersten Ausführungsbeispiel. Damit ergibt sich in jedem Transformator 27 dasselbe Wicklungsverhältnis von 3:1. Jede Sekundärwicklung 31 ist parallel zu dem ihr zugeordneten Akkumulator 2 geschaltet. In der ein höheres Potential aufweisenden Sekundärseitenleitung 32 oder in der ein niedrigeres Potential aufweisenden Sekundärseitenleitung 33 ist jeweils die Sperrdiode 30 angeordnet.

Die jeweilige Spannung jedes Akkumulators 2 wird mit seiner Sollspannung in der Vergleichsschaltung 17 verglichen und das Ergebnis direkt in Gestalt einer analogen Spannung oder als Ausgangssignal eines Komparators an die dem Akkumulator 2 zugeordnete Ansteuerschaltung 22 weitergeleitet. Falls die Istspannung eines Akkumulators 2 kleiner als seine Sollspannung ist, die bei drei gleichen Akkumulatoren 2 üblicherweise dem dritten Teil der Gesamtspannung entspricht, wird dies von seiner Vergleichsschaltung 17 erfaßt. Zur Unterstützung des Ladungsvorgangs dieses schwachen Akkumulators 2 löst das auf der Steuerleitung 21 die zugehörige Ansteuerschaltung 22 beaufschlagende Differenzsignal das Einschalten des Rechteckgenerators aus, der den Unterbrecher 25 in einem schnellen Wechsel öffnet und schließt. Die an der Primärwicklung 26 des entsprechenden Transformators 27 anliegende Spannung induziert eine Spannung an den Sekundärwicklungen 31, die der Sollspannung der Akkumulatoren 2 entspricht.

Sinkt ein Akkumulator 2 unter die Sollspannung, so wird ihm über den Sperrwandler des Überwachungsmodules 10 Energie aus den anderen Akkumulatoren 2 zugeführt. Im Idealfall ist der über den Sperrwandler zugeführte Strom im zeitlichen Mittel so groß wie der Entladestrom der Akkumulatorengruppe, so daß keine wesentlichen Ladungsmengen in den schwachen Akkumulator 2 hineinfließen. Hierdurch wird der schwache Akkumulator 2 entlastet und es werden Verluste durch Ladungs- bzw. Entladungsvorgänge vermieden.

Die Fig. 3 zeigt ein Schaltbild einer Realisierungsmöglichkeit für die Vergleichsschaltung 17. Die Anschlußleitung 19, die in der Fig. 1 nur schematisch dargestellt war, verläuft zwischen dem Anschlußpunkt der positiven Sollspannung 50 und dem Anschlußpunkt der negativen Sollspannung 51. In die Anschlußleitung 19 sind drei gleiche Widerstände 52 eingebracht, so daß an den Abgriffpunkten 53 ein Drittel der Sollspannung anliegt. Damit liegt im normalen Betriebsfall die Eingangsspannung des Elektrometer-Differenz-Verstärkers, der aus den Operationsverstärkern 54, 55 und 56 gebildet wird, immer innerhalb des Akkumulatorspannungsbereichs, was eine unipolare Versorgung dieser Operationsverstärker 54, 55 und 56 aus demselben Akkumulator 2 ermöglicht. Die Schutzdioden 57 und 58, die mit den an die Anschlußpunkte 11 und 12 des Akkumulators 12 angeschlossenen Istwertleitungen 13 und 14 verbunden sind, schützen zusammen mit hochohmigen Widerständen 60 die Eingänge der Operationsverstärker bei extremen Verschiebungen der Spannungslagen.

Die nicht-invertierenden Eingänge der Operationsverstärker 54 und 55 sind über die hochohmigen Widerstände 60 mit den Abgriffpunkten 53 verbunden. Sie sind weiterhin über die Schutzdioden 57 und 58 mit den Anschlußpunkten 11 und 12 des Akkumulators 2 verbunden. Die Ausgänge der Operationsverstärker 54 und 55 sind direkt mit ihren invertierenden Eingängen gegengekoppelt. Ihre Ausgänge sind über zwei im Widerstandswert gleiche Widerstände 61 mit den Eingängen des dritten Operationsverstärkers 56 verbunden. Der nicht-invertierende Eingang des dritten Operationsverstärkers 56 ist über einen weiteren ebenfalls den gleichen Widerstandswert aufweisenden Widerstand 61 mit der Anschlußleitung 14 verbunden. Der Operationsverstärker 56 ist über einen im Widerstandswert mit den Widerständen 61 übereinstimmenden Rückkopplungswiderstand 61′ auf seinen invertierenden Eingang zurückgekoppelt.

An dem Ausgang 62 des Operationsverstärkers 56 liegt eine Spannung von einem Drittel der zwischen den Anschlußpunkten 50 und 51 anliegenden Sollspannung. Diese wird einem Fensterkomparator 63 zugeführt, der aus zwei Operationsverstärkern 64 und 65 aufgebaut ist. Diese Spannung wird mit einer an den anderen Eingängen der Operationsverstärker 64 und 65 anliegenden Spannung verglichen, die einem Drittel der Spannung des Akkumulators 2 entspricht. Diese wird durch einen aus den Widerständen 67 und 68 bestehenden Spannungsteiler erzeugt, wobei der Widerstand 67 den doppelten Widerstandswert des Widerstands 68 aufweist.

Ein Ausgleich der durch unterschiedliche Temperaturen der Akkumulatoren hervorgerufenen Differenzen der Sollspannung kann durch ein temperaturabhängiges Widerstandsnetzwerk anstelle der Widerstände 67 und 68 herbeigeführt werden.

Der Fensterkomparator 63 weist eine Hysterese auf, die mit den Einstellwiderständen 70 und 71 im Rückkopplungskreis der Operationsverstärker 64 und 65 festgelegt ist. Dies verhindert ein instabiles Verhalten des Fensterkomparators 63. Wird die Vergleichsschaltung 17 in Verbindung mit der Anordnung nach Fig. 1 eingesetzt, so werden die Ausgänge 72 und 73 der Operationsverstärker 64 und 65 mit Hilfe von zwei Schaltdioden 74 und 75 ODER-verknüpft und steuern über einen Verlustwiderstand 76 einen opto-elektronischen Koppler 77 an. Die verschiedenen opto-elektronischen Koppler 77 der einzelnen Vergleichsschaltungen 17 sind in einer ODER-Verknüpfung über die Ansteuerleitung 21 mit der Ansteuerschaltung 22 verbunden.

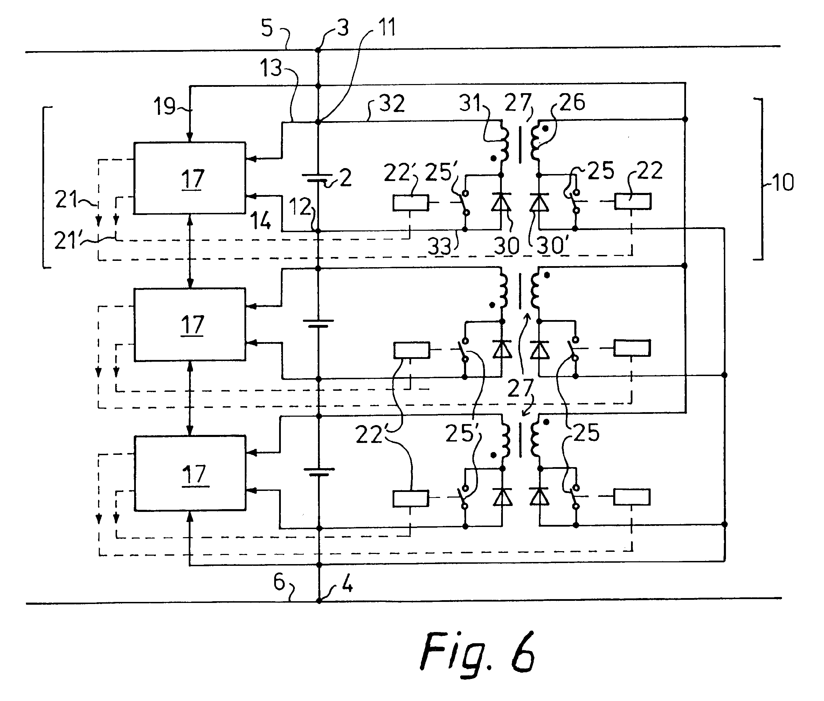

Bei einer Kombination der Vergleichsschaltung 17 mit der Anordnung gemäß Fig. 6 entfallen die zur ODER-Verknüpfung erforderlichen Dioden 74 und 75. Die Ansteuerschaltung 22′ wird direkt vom Ausgang 72 des Operationsverstärkers angesteuert, während die Ansteuerschaltung 22 über den Optokoppler 77 vom Ausgang des Operationsverstärkers 65 beaufschlagt wird.

Vorzugsweise sind zwischen den Ausgängen 72 und 73 des Fensterkomparators 63 und der Leitung 14 des Überwachungsmodules 10 zwei Betriebsstundenzähler eingesetzt, die die Zeit messen, in denen sich der entsprechende Akkumulator 2 im Überspannungs- bzw. Unterspannungsbereich befunden hat.

In einer weiteren in der Fig. 3 nicht dargestellten Ausführungsform der Vergleichsschaltung 17 sind Verlustwiderstände 76 an die Ausgänge 72 und 73 angeschlossen, die über zwei die Dioden 74 und 75 ersetzende Leuchtdioden mit dem opto-elektronischen Koppler 77 verbunden sind. Somit ist zusätzlich zu den Betriebsstundenzählern eine laufende Erfassung des Überschreitens der Fenstergrenzwerte des Fensterkomparators 63 mit einer optischen Anzeige in einfacher Weise möglich.

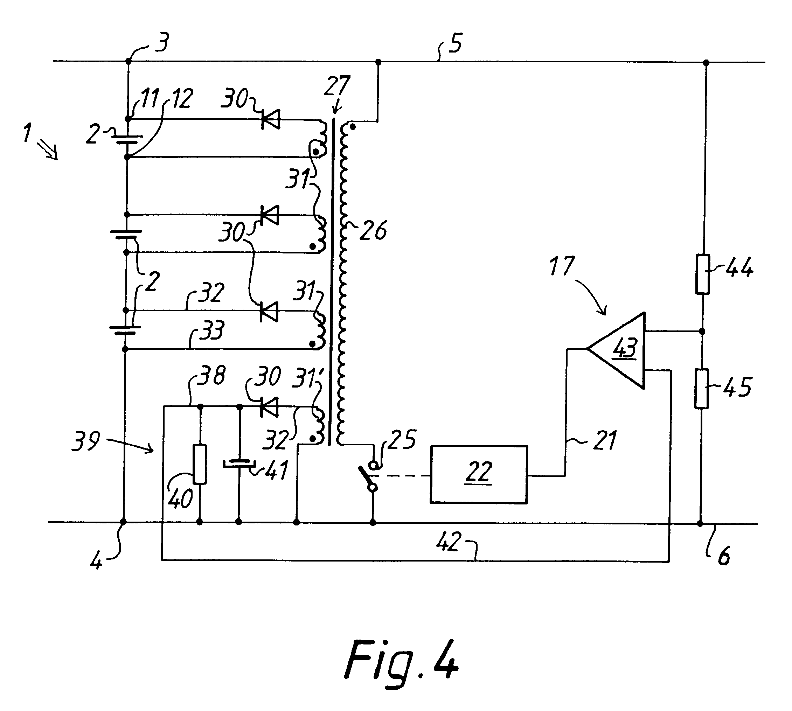

Die Fig. 4 zeigt ein Blockschaltbild einer Überwachungseinrichtung 1 für Akkumulatoren 2 zur Überwachung von z.B. drei Akkumulatoren 2. Gleiche Merkmale dieser Überwachungseinrichtung 1 tragen die gleichen Bezugszeichen wie in den Fig. 1 und 2.

Zwischen den Hauptleitungen 5 und 6 ist ein Spannungsteiler aus zwei Widerständen 44 und 45 realisiert, wobei der Widerstandswert des Widerstandes 44 zweimal so groß ist wie der Widerstandswert des Widerstandes 45. Bei der Überwachung von n Akkumulatoren 2 ist der Widerstandswert des Widerstandes n-1 mal größer als der des Widerstandes 45.

Am Eingang eines Komparators 43 liegt also eine Sollspannung von einem Drittel oder n-tel der Gesamtspannung der Akkumulatorengruppe an. Der Komparator 43 bildet zusammen mit den Widerständen 44 und 45 die Vergleichsschaltung 17, deren Ausgangssignal auf der Steuerleitung 21 die Ansteuerschaltung 22 mit dem Funktionsgenerator beaufschlagt. Die Ansteuerschaltung 22 beinhaltet zudem eine Zeitschaltung, die den Rechteckgenerator nur in vorbestimmten Zeitintervallen anschaltet und nur bei dann gemeldeten Abweichungen der Istspannungen der Akkumulatoren 2 den Rechteckgenerator zum Spannungsausgleich eingeschaltet beläßt.

Das Ausgangssignal des Rechteckgenerators beaufschlagt einen Unterbrecher 25. Der Unterbrecher 25 ist zwischen den Hauptleitungen 5 und 6 in Reihe mit einer Primärwicklung 26 eines Transformators 27 angeordnet. Die Unterbrecher 25 und die Primärwicklung 26 sind parallel zu der Akkumulatorgruppe geschaltet.

Die Sekundärseite des Transformators 27 beinhaltet eine Anzahl von Sekundärwicklungen 31 und 31′, die der Anzahl der zu überwachenden Akkumulatoren 2 plus eine entspricht. Die in der Fig. 4 dargestellten vier Sekundärwicklungen 31 und 31′ verfügen alle über die gleiche Anzahl von Windungen, wobei die Summe aller Windungen der Sekundärwicklungen 31 vorteilhafterweise der Anzahl der Windungen der Primärwicklung 26 entspricht. Gegenüber jeder Sekundärwicklung 31 und 31′ ergibt sich also ein Windungsverhältnis von 3:1.

Jede Sekundärwicklung 31 ist parallel zu dem ihr zugeordneten Akkumulator 2 geschaltet. In der ein höheres Potential aufweisenden Sekundärseitenleitung 32 oder in der ein niedrigeres Potential aufweisenden Sekundärseitenleitung 33 ist eine Sperrdiode 30 angeordnet.

Die Hilfswicklung 31′ dient der Erzeugung einer Spannung, die der Spannung des Akkumulators 2 mit der kleinsten Istspannung entspricht. Die Hilfswicklung 31′ ist mit der Hauptleitung 6 verbunden. Der auf dem höheren Potential liegende Abgriff der Hilfswicklung 31′ ist über eine anodenseitig beschaltete Diode 30 mit dem Spannungsabgriff 38 verbunden. Der Spannungsabgriff 38 ist über eine Parallelschaltung eines Widerstandes 40 und eines Kondensators 41 an die Hauptleitung 6 angeschlossen. Diese bilden einen Spannungsmesser 39, dessen Ausgangssignal über eine Spannungszustandsleitung 42 in die Vergleichsschaltung 17 eingespeist wird. Das Ausgangssignal des Komparators 43 wird der Ansteuerschaltung 22 zugeführt. Falls die Istspannung eines der Akkumulatoren 2 kleiner ist als die vorgegebene Sollspannung, die bei drei gleichen Akkumulatoren 2 üblicherweise dem dritten Teil der Gesamtspannung entspricht, wird dies über den Spannungsmesser 39 von der Vergleichsschaltung 17 erfaßt. Zur Unterstützung des Ladungsvorgangs dieses eines schwachen Akkumulators 2 löst das die Steuerleitung 21 beaufschlagende Differenzsignal das Einschalten des Rechteckgenerators aus, der den Unterbrecher 25 in ein schnelles Öffnen und Schließen versetzt.

Die Fig. 5 zeigt schließlich eine andere Ausgestaltungsmöglichkeit der Vergleichsschaltung 17. Ein Analog-Digital-Wandler 91, der mit der Spannung zwischen den Anschlußleitungen 5 und 6 beaufschlagt ist, erstellt ein digitales, der Sollspannung entsprechendes Signal, das über die Digitalleitung 92 in die Vergleichsschaltungen 17 eingespeist wird. Das digitale Signal kann in Pulsbreitenmodulation oder in frequenzkodierter Form vorliegen. In einem opto-elektronischen Koppler 93 wird das digitale Signal zur Potentialtrennung übertragen und in einem zu jeder Vergleichsschaltung 17 gehörenden Digital-Analog-Wandler 94 in ein analoges Signal zurückgewandelt, das in einem Komparator 90 mit der an den Anschlußpunkten 11 und 12 abgegriffenen Ist-Spannung des jeweiligen Akkumulators 2 verglichen wird.

Das in der Fig. 6 dargestellte vierte Ausführungsbeispiel weist ebenfalls einen vorteilhaften modularen Aufbau auf, der Überwachungsmodule 10 vorsieht, die jeweils aus einem symmetrisch aufgebauten bidirektional arbeitenden Sperrwandler mit den Dioden 30 und 30′, einem Transformator 27, den Unterbrechern 25 und 25′, zugehörigen Ansteuerschaltungen 22 und 22′ sowie einer Vergleichsschaltung 17 aufgebaut sind. Gleiche Merkmale tragen die gleichen Bezugszeichen wie in den Fig. 1 und 2 bei den beiden ersten Ausführungsbeispielen.

Die zwischen den Anschlußpunkten 11 und 12 abgegriffene Spannung jeden Akkumulators 2 beaufschlagt über die Istwertleitungen 13 und 14 jeweils eine Vergleichsschaltung 17. Die Vergleichsschaltung 17 bildet aus der durch die Außenleitung 19 vorgegebenen, augenblicklichen Sollspannung des Akkumulators 2 und der augenblicklichen Istspannung des Akkumulators 2 eine Differenzspannung, die über schematisch dargestellte Steuerleitungen 21 und 21′ die dem jeweiligen Akkumulator 2 zugeordneten Ansteuerschaltungen 22 bzw. 22′ beaufschlagt.

Jede Ansteuerschaltung 22 bzw. 22′ umfaßt einen Rechteck-Funktionsgenerator. Entsprechend dem ersten und zweiten Ausführungsbeispiel ist vorteilhafterweise ein Anlaufschutz sowie eine elektronische Überstrombegrenzung für jedes Überwachungsmodul 10 vorgesehen. Abhängig vom Steuersignal der Vergleichsschaltung arbeitet entweder die in Fig. 6 dargestellte linke oder rechte Seite des Sperrwandlers als Primär- bzw. Sekundärseite. Im Folgenden soll mit Primärwicklung die rechte, dem Unterbrecher 25 zugeordnete Wicklung 26 bezeichnet werden. Das Ausgangssignal des Rechteckgenerators beaufschlagt einen dem Überwachungsmodul 10 zugeordneten Unterbrecher 25. Der Unterbrecher 25 ist zwischen den Hauptleitungen 5 und 6 in Reihe mit einer Primärwicklung 26 eines dem besagten Akkumulator 2 zugeordneten Transformators 27 angeordnet. Die in Reihe mit den Primärwicklungen 26 angeordneten Unterbrecher 25 sind alle jeweils parallel zu der Akkumulatorengruppe geschaltet und bilden einzelne Sperrwandler.

Jede der Primärwicklungen 26 weist eine Wicklungszahl entsprechend der Wicklungszahl der Primärwicklungen 26 aus dem zweiten Ausführungsbeispiel entspricht. Die Sekundärseite jedes Transformators 27 beinhaltet eine Sekundärwicklung 31 mit der gleichen Anzahl von Windungen wie jede der Sekundärwicklungen 31 im zweiten Ausführungsbeispiel. Damit ergibt sich in jedem Transformator 27 dasselbe Wicklungsverhältnis von 3:1. Jede Sekundärwicklung 31 ist parallel zu dem ihr zugeordneten Akkumulator 2 geschaltet. In der ein niedrigeres Potential aufweisenden Sekundärseitenleitung 33 ist jeweils die Parallelschaltung einer Sperrdiode 30′ mit einem Unterbrecher 25′ angeordnet.

Die jeweilige Spannung jedes Akkumulators 2 wird mit seiner Sollspannung in der Vergleichsschaltung 17 verglichen und das Ergebnis direkt in Gestalt einer analogen Spannung oder als Ausgangssignal eines Komparators an die dem Akkumulator 2 zugeordneten Ansteuerschaltungen 22 bzw. 22′ weitergeleitet. Falls die Istspannung eines Akkumulators 2 kleiner als seine Sollspannung ist, die bei drei gleichen Akkumulatoren 2 üblicherweise dem dritten Teil der Gesamtspannung entspricht, wird dies von seiner Vergleichsschaltung 17 erfaßt. Zur Unterstützung des Ladungsvorgangs dieses schwachen Akkumulators 2 löst das auf der Steuerleitung 21 die zugehörige Ansteuerschaltung 22 beaufschlagende Differenzsignal das Einschalten des Rechteckgenerators aus, der den Unterbrecher 25 in einem schnellen Wechsel öffnet und schließt. Die an der Primärwicklung 26 des entsprechenden Transformators 27 anliegende Spannung induziert eine Spannung an den Sekundärwicklungen 31, die der Sollspannung der Akkumulatoren 2 entspricht.

Bei der Anordnung nach Fig. 6 sind drei mögliche Betriebszustände zu unterscheiden: Der Normalfall liegt vor, wenn alle Akkumulatorspannungen innerhalb eines vorgegebenen Toleranzfeldes liegen, so daß beide Ansteuerschaltungen 22 bzw. 22′ außer Betrieb sind. Die Vorrichtung erfüllt dann eine reine Überwachungsaufgabe. Sinkt entsprechend einem zweiten Fall eine Akkumulatorspannung unter den vorgegebenen Wert, so wird dies von der Vergleichsschaltung 17 erkannt und die Steuerleitung 21 aktiviert. Die Ansteuerschaltung 22 betätigt den Unterbrecher 25, wodurch Energie aus dem Gesamtakkumulator entnommen wird und über den Transformator und die Diode 30 dem zugeordneten Akkumulator 2 zugeführt wird. Im dritten möglichen Fall übersteigt die Akkumulatorspannung den Sollwert. Dann wird über die Steuerleitung 21′ die Ansteuerschaltung 22′ beaufschlagt, welche wiederum den Unterbrecher 25′ betätigt. Dies führt zu einem Energiefluß über den Transformator und die Sperrdiode 30′ in das Gesamtakkumulatorensystem bzw. in die angeschlossene Last.

## Patentansprüche

1. Überwachungseinrichtung (1) für eine Vielzahl von in Reihe geschalteten, gleichartigen Akkumulatoren (2), mit einer Steuerschaltung (22) zum Zuschalten eines elektrischen Speichers parallel zu einem der Akkumulatoren (2), wobei die Primärwicklung (26) eines Transformators (27) in Reihe mit einem an die Steuerschaltung (22) angeschlossenen Unterbrecher (25) parallel zu den Polen (3,4) der Gruppe von Akkumulatoren (2) verbunden ist, **dadurch gekennzeichnet**, daß die Polanschlüsse (11,12) jeden Akkumulators (2) über jeweils eine einen Rückstrom aus dem Akkumulator (2) unterbindende Diode (30) mit einer zugeordneten und den elektrischen Speicher bildenden Sekundärwicklung (31) des Transformators (27) verbunden sind, wobei ein einziger Transformator (27) vorgesehen ist, der eine Anzahl von Sekundärwicklungen (31) umfaßt, die der Anzahl der Akkumulatoren (2) entspricht, und daß jeder Akkumulator (2) mit einer Vergleichsschaltung (17) verbunden ist, deren jeweilige Ausgangssignale in einer ODER-Verknüpfungsschaltung einen Eingang der Steuerschaltung (22) beaufschlagen, die bei einem Istspannungs-Differenzsignal einen in der Steuerschaltung (22) vorgesehenen Funktionsgenerator anschaltet, dessen Ausgang mit dem Unterbrecher (25) verbunden ist

2. Überwachungseinrichtung (1) für eine Vielzahl von in Reihe geschalteten, gleichartigen Akkumulatoren (2), mit einer Steuerschaltung (22) zum Zuschalten eines elektrischen Speichers parallel zu einem der Akkumulatoren (2), wobei die Primärwicklung (26) eines Transformators (27) in Reihe mit einem an die Steuerschaltung (22) angeschlossenen Unterbrecher (25) parallel zu den Polen (3,4) der Gruppe von Akkumulatoren (2) verbunden ist, **dadurch gekennzeichnet**, daß die Polanschlüsse (11,12) jeden Akkumulators (2) über jeweils eine einen Rückstrom aus dem Akkumulator (2) unterbindende Diode (30) mit einer zugeordneten und den elektrischen Speicher bildenden Sekundärwicklung (31) des Transformators (27) verbunden sind, wobei ein einziger Transformator (27) vorgesehen ist, der eine Anzahl von Sekundärwicklungen (31) umfaßt, deren Anzahl um eins erhöht ist gegenüber der Zahl der Akkumulatoren (2), und daß die über die Anzahl der Akkumulatoren (2) hinaus vorgesehene Hilfssekundärwicklung (31′) mit einem Spannungsmesser (39) verbunden ist, dessen Ausgang mit einer Vergleichsschaltung (17) verbunden ist, deren Ausgangssignal einen Eingang der Steuerschaltung (22) beaufschlagt, die bei einem Istspannungs-Differenzsignal einen in der Steuerschaltung (22) vorgesehenen Funktionsgenerator anschaltet, dessen Ausgang mit dem Unterbrecher (25) verbunden ist, und daß eine Zeitschaltung in der Steuerschaltung (22) vorgesehen ist, die den Funktionsgenerator periodisch zeitweilig und unabhängig von einem Istspannungs-Differenzsignal anschaltet

3. Überwachungseinrichtung (1) für eine Vielzahl von in Reihe geschalteten, gleichartigen Akkumulatoren (2), mit einer Steuerschaltung (22) zum Zuschalten eines elektrischen Speichers parallel zu einem der Akkumulatoren (2), wobei die Primärwicklung (26) eines Transformators (27) in Reihe mit einem an die Steuerschaltung (22) angeschlossenen Unterbrecher (25) parallel zu den Polen (3,4) der Gruppe von Akkumulatoren (2) verbunden ist, **dadurch gekennzeichnet**, daß die Polanschlüsse (11,12) jeden Akkumulators (2) über jeweils eine einen Rückstrom aus dem Akkumulator (2) unterbindende Diode (30) mit einer zugeordneten und den elektrischen Speicher bildenden Sekundärwicklung (31) des Transformators (27) verbunden sind, wobei eine Anzahl von Überwachungsmodulen (10) vorgesehen ist, die jeweils einen Transformator (27) und einen mit dessen Primärwicklung (26) in Reihe geschalteten Unterbrecher (25) je zu überwachenden Akkumulator (2) umfassen, wobei jeder Akkumulator (2) mit einer Vergleichsschaltung (17) verbunden ist, deren Ausgang mit dem Eingang der dem jeweiligen Akkumulator (2) zugeordneten Steuerschaltung (22) verbunden ist, die einen den Unterbrecher (25) ansteuernden Funktionsgenerator umfaßt.

4. Überwachungseinrichtung nach Anspruch 3, dadurch gekennzeichnet, daß jedes Überwachungsmodul (10) einen mit dessen Sekundärwicklung (31) in Reihe und zu der einen Rückstrom aus dem Akkumulator (2) unterbindenden Diode (30) parallel geschalteten zweiten Unterbrecher (25′) umfaßt, daß der Ausgang der Vergleichsschaltung (17) mit dem Eingang einer dem jeweiligen Akkumulator (2) zugeordneten zweiten Steuerschaltung (22′) verbunden ist, die einen den zweiten Unterbrecher (25′) ansteuernden Funktionsgenerator umfaßt, und daß eine Sperrdiode (30′) parallel zum primärwicklungsseitig angeordneten Unterbrecher (25) geschaltet ist

5. Überwachungseinrichtung nach Anspruch 3 oder 4, dadurch gekennzeichnet, daß die mindestens eine Diode (30, 30′) und der mindestens eine Unterbrecher (25, 25′) in der ein niedrigeres Potential aufweisenden Primär- bzw. Sekundärseitenleitung (4,33) angeordnet ist.

6. Überwachungseinrichtung nach einem der vorstehenden Ansprüche, dadurch gekennzeichnet, daß mit der Vergleichsschaltung (17) die Abweichung der Akkumulatorspannung von einer Sollspannung nach oben und nach unten meßbar ist und daß bei einer solchen Abweichung ein Istspannungs-Differenzsignal der Vergleichsschaltung (17) die Steuerschaltung (22) beaufschlagt.

7. Überwachungseinrichtung nach einem der vorstehenden Ansprüche, dadurch gekennzeichnet, daß der Funktionsgenerator der Steuerschaltung (22) ein Rechteck-Ausgangssignal mit einer Frequenz im Kilohertzbereich und einem Tastverhältnis von kleiner als 50 Prozent erzeugt.

8. Überwachungseinrichtung nach Anspruch 7, dadurch gekennzeichnet, daß der Funktionsgenerator einen Anlaufschutz umfaßt, der beim Einschalten des Funktionsgenerators das Tastverhältnis von null Prozent auf den vorbestimmten Wert ändert.

9. Überwachungseinrichtung nach einem der Ansprüche 1 bis 8, dadurch gekennzeichnet, daß der Unterbrecher (25) einen MOS-Feldeffekttransistor oder einen bipolaren Transistor umfaßt.

## Claims

1. Monitoring device (1) for a plurality of similar accumulators (2), incorporated in series, with a control circuit (22) for connecting to an electrical store parallel to one of the accumulators (2), the primary winding (26) of a transformer (27) being connected in series with a circuit breaker (25) connected to the control circuit (22), and parallel to the poles (3, 4) of the group of accumulators (2), characterised in that the pole connections (11, 12) of each accumulator (2) are connected via a respective diode (30) preventing return current from the accumulator (2) to an associated secondary winding (31) forming the electrical store of the transformer (27), a single transformer (27) being provided which includes a number of secondary windings (31) which corresponds to the number of accumulators (2), and in that each accumulator (2) is connected to a comparator circuit (17) the respective output signals of which, in an OR combinatorial circuit, are applied to an input of the control circuit (22) which, in the case of an actual-voltage differential signal, switches on a function generator provided in the control circuit (22), and whose output is connected to the circuit breaker (25).

2. Monitoring device (1) for a plurality of similar accumulators (2), incorporated in series, with a control circuit (22) for connecting to an electrical store parallel to one of the accumulators (2), the primary winding (26) of a transformer (27) being connected in series with a circuit breaker (25) connected to the control circuit (22), and parallel to the poles (3, 4) of the group of accumulators (2), characterised in that the pole connections (11, 12) of each accumulator (2) are connected via a respective diode (30) preventing return current from the accumulator (2) to an associated secondary winding (31) forming the electrical store of the transformer (27), a single transformer (27) being provided which includes a number of secondary windings (31) whose number is increased by one relative to the number of accumulators (2), and in that the auxiliary secondary winding (31′) provided above the number of accumulators (2) is connected to a volt meter (39) whose output is connected to a comparator circuit (17) whose output signal is applied to an input of the control circuit (22) which, upon occurrence of an actual-voltage differential signal, switches on a function generator provided in the control circuit (22) and whose output is connected to the circuit breaker (25), and in that there is provided in the control circuit (22) a timer circuit which switches on the function generator at periodic time intervals independently of the actual-voltage differential signal.

3. Monitoring device (1) for a plurality of similar accumulators (2), incorporated in series, with a control circuit (22) for connecting to an electrical store parallel to one of the accumulators (2), the primary winding (26) of a transformer (27) being connected in series with a circuit breaker (25) connected to the control circuit (22), and parallel to the poles (3, 4) of the group of accumulators (2), characterised in that the pole connections (11, 12) of each accumulator (2) are connected via a respective diode (30) preventing return current from the accumulator (2) to an associated secondary winding (31) forming the electrical store of the transformer (27), there being provided a plurality of monitoring modules (10) respectively including a transformer (27) and a circuit breaker (25) incorporated in series with the primary winding (26) of said transformer (25) for each accumulator (2) to be monitored, each accumulator (2) being connected to a comparator circuit (17) whose output is connected to the input of the control circuit (22) associated with the respective accumulator (2), said control circuit (22) including a function generator triggering the circuit breaker (25).

4. Monitoring device according to claim 3, characterised in that each monitoring module (10) includes a second circuit breaker (25) incorporated in series with its secondary winding (31) and in parallel with the diode (30) preventing return voltage from the accumulator (2), in that the output of the comparator circuit (17) is connected to the input of a second control circuit (22′) associated with the respective accumulator (2), said control circuit (22′) including a function generator triggering the second circuit breaker (25′), and in that a blocking diode (30′) is incorporated in parallel with the circuit breaker (25) located on the primary winding side.

5. Monitoring device according to claim 3 or 4, characterised in that the at least one diode (30, 30′) and the at least one circuit breaker (25, 25′) are located in the primary or secondary-side cable (4, 33) having a lower potential.

6. Monitoring device according to one of the preceding claims, characterised in that by means of the comparator circuit (17) the fluctuation of the accumulator voltage upwards and downwards from a required voltage may be measured, and in that upon such a fluctuation an actual-voltage differential signal from the comparator circuit (17) is applied to the control circuit (22).

7. Monitoring device according to one of the preceding claims, characterised in that the function generator of the control circuit (22) generates a square wave output signal with a frequency in the kilohertz range and with a pulse width repetition rate of less than 50 percent.

8. Monitoring device according to claim 7, characterised in that the function generator includes a start protection system which changes the pulse width repetition rate from zero percent. to the prescribed value when the function generator is switched on.

9. Monitoring device according to one of claims 1 to 8, characterised in that the circuit breaker (25) includes a MOS field-effect transistor or a bipolar transistor.

## Revendications

1. Dispositif de contrôle (1) pour une multiplicité d'accumulateurs identiques (2) branchés en série, comprenant un circuit de commande (22) pour raccorder une unité d'accumulation électrique en parallèle avec l'un des accumulateurs (2), l'enroulement primaire (26) d'un transformateur (27) étant relié en série avec un interrupteur (25), qui est raccordé au circuit de commande (22), parallèlement aux pôles (3,4) du groupe d'accumulateurs (2), caractérisé par le fait que les bornes polaires (11,12) de chaque accumulateur (2) sont reliées par l'intermédiaire respectivement d'une diode (30) qui bloque un courant de retour à partir de l'accumulateur (2), à un enroulement secondaire associé (31), qui forme l'unité d'accumulation électrique, du transformateur (27), et dans lequel il est prévu un seul transformateur (27), qui comprend un nombre d'enroulements secondaires (31), qui correspond au nombre des accumulateurs (2), et que chaque accumulateur (2) est relié à un circuit comparateur (17), dont les signaux respectifs de sortie chargent, dans un circuit combinatoire OU, une entrée du circuit de commande (22), qui, dans le cas d'un signal de différence de tension réelle, branche un générateur de fonction, qui est prévu dans le circuit de commande (22) et dont la sortie est reliée à l'interrupteur (25).

2. Dispositif de contrôle (1) pour une multiplicité d'accumulateurs identiques (2) branchés en série, comprenant un circuit de commande (22) pour raccorder une unité d'accumulation électrique en parallèle avec l'un des accumulateurs (2), l'enroulement primaire (26) d'un transformateur (27) étant relié en série avec un interrupteur (25), qui est raccordé au circuit de commande (22), parallèlement aux pôles (3,4) du groupe d'accumulateurs (2), caractérisé par le fait que les bornes polaires (11,12) de chaque accumulateur (2) sont raccordées par l'intermédiaire respectivement d'une diode (30), qui bloque un courant de reflux à partir de l'accumulateur (2), à un enroulement secondaire associé (31), qui constitue l'unité d'accumulation électrique, du transformateur (27), et dans lequel il est prévu un seul transformateur (27), qui comporte un nombre d'enroulements secondaires (31), qui est accru d'une unité par rapport au nombre des accumulateurs (2), et que l'enroulement auxiliaire (31′), prévu en plus du nombre des accumulateurs (2), est relié à un voltmètre (39), dont la sortie est reliée à un circuit comparateur (17), dont le signal de sortie charge une entrée du circuit de commande (22) qui, dans le cas d'un signal de différence de tension réelle, branche un générateur de fonction prévu dans le circuit de commande (22) et dont la sortie est reliée à l'interrupteur (25), et qu'il est prévu, dans le circuit de commande (22), une minuterie, qui raccorde le générateur de fonction par instants de façon périodique et indépendamment du signal de différence de tension réelle.

3. Dispositif de contrôle (1) pour une multiplicité d'accumulateurs identiques (2) branchés en série, comprenant un circuit de commande (22) pour raccorder une unité d'accumulation électrique en parallèle avec l'un des accumulateurs (2), l'enroulement primaire (26) d'un transformateur (27) étant relié en série avec un interrupteur (25), qui est raccordé au circuit de commande (22), parallèlement aux pôles (3,4) du groupe d'accumulateurs (2), caractérisé par le fait que les bornes polaires (11,12) de chaque accumulateur (2) sont reliées par l'intermédiaire respectivement d'une diode (30) bloquant un courant de retour à partir de l'accumulateur (2), à un enroulement secondaire associé (31), qui constitue l'unité d'accumulation électrique, du transformateur (27), et qu'il est prévu un nombre de modules de contrôle (10), qui comportent chacun un transformateur (27) et un interrupteur (25), branché en série avec l'enroulement primaire (26) de ce transformateur, pour chaque accumulateur (2) devant être contrôlé, et que chaque accumulateur (2) est relié à un circuit comparateur (17), dont la sortie est raccordée à l'entrée du circuit de commande (22) associé à l'accumulateur respectif (2) et qui comprend un générateur de fonction commandant l'interrupteur (25).

4. Dispositif de contrôle suivant la revendication 3, caractérisé par le fait que chaque module de contrôle (10) comporte un second interrupteur (25′), qui est branché en série avec l'enroulement secondaire (31) de ce module et en parallèle avec la diode (30) qui bloque un courant de retour en provenance de l'accumulateur (2), que la sortie du circuit comparateur (17) est reliée à l'entrée d'un second circuit de commande (22′), qui est associé à l'accumulateur respectif (2) et qui comprend un générateur de fonctions qui commande le second interrupteur (25′), et qu'une diode de blocage (30′) est branchée en parallèle avec l'interrupteur (25) disposé du côté de l'enroulement primaire.

5. Dispositif de contrôle suivant la revendication 3 ou 4, caractérisé par le fait que la ou les diodes (30,30′) et le ou les interrupteurs (25,25′) sont disposés dans la ligne (4,33) située côté primaire ou côté secondaire, qui possède un potentiel inférieur.

6. Dispositif de contrôle suivant l'une des revendications précédentes, caractérisé en ce que l'écart vers le haut et vers le bas entre la tension de l'accumulateur et une tension de consigne peut être mesuré avec le circuit comparateur (17) et que, dans le cas d'un tel écart, un signal de différence de tension réelle du circuit comparateur (17) charge le circuit de commande (22).

7. Dispositif de contrôle suivant l'une des revendications précédentes, caractérisé par le fait que le générateur de fonction du circuit de commande (22) produit un signal de sortie rectangulaire possédant une fréquence située dans la gamme des kilohertz et un taux d'impulsions inférieur à 50 pour cent.

8. Dispositif de contrôle suivant la revendication 7, caractérisé par le fait que le générateur de fonction comprend un circuit de protection en démarrage, qui lors du branchement du générateur de fonction, modifie le taux d'impulsions de zéro pour cent à la valeur prédéterminée.

9. Dispositif de contrôle suivant l'une des revendications 1 à 8, caractérisé par le fait que l'interrupteur (25) possède un transistor à effet de champ MOS ou un transistor bipolaire.
